# EUROPEAN PATENT SPECIFICATION

(11) **EP 3 127 239 B1**
(45) Date of publication and mention of the grant of the patent: **05.12.2018**
(21) Application number: 15713821.5
(22) Date of filing: 04.03.2015
(51) Int. Cl.: H03K 3/03, G01R 31/317, H03K 19/003, H03K 5/01, G01R 31/28

(54) **AGING SENSOR FOR AN INTEGRATED CIRCUIT**
ALTERUNGSSENSOR EINER INTEGRIERTEN SCHALTUNG
DÉTECTEUR DE VIEILLISSEMENT DE CIRCUIT INTÉGRÉ

(30) Priority: 01.04.2014 US 201461973765 P; 06.10.2014 US 201414507679
(43) Date of publication of application: 08.02.2017
(73) Proprietor: Qualcomm Incorporated, San Diego, CA 92121-1714 (US)
(72) Inventor: LIU, Jonathan, San Diego, CA 92121-1714 (US); IBRAHIMOVIC, Jasmin Smaila, San Diego, CA 92121-1714 (US); DIFFENDERFER, Jan Christian, San Diego, CA 92121-1714 (US); AUYON, Carlos, San Diego, CA 92121-1714 (US)
(74) Representative: Schmidbauer, Andreas Konrad
(86) International application number: PCT/US2015/018785
(87) International publication number: WO 2015/153048

(56) References cited:
- US-A1- 2005 134 394
- US-A1- 2006 223 201
- US-A1- 2011 090 015
- US-A1- 2011 102 064
- US-A1- 2011 173 432
- US-B1- 6 903 564

## Description

### BACKGROUND

### Field

The present invention relates to integrated circuits and, more particularly, to systems and methods for dynamically de-aging integrated circuit performance.

### Background

Integrated circuits have grown increasingly complex. To improve trade-offs between performance and power, an integrated circuit may operate at different frequencies and different voltages at different times. For example, an integrated circuit may operate in various frequency-voltage modes that include a high-performance mode and a low-power mode. The high-performance mode uses a high clock frequency and high supply voltage and thus provides high performance but also has high power consumption. The low-power mode uses a low clock frequency and low supply voltage and thus provides low power consumption but also has low performance. Additionally, various blocks inside an integrated circuit may operate at different frequencies and at different voltages.

The specific supply voltage that provides for a given clock frequency can vary based on various conditions. For example, manufacturing variations may result in different integrated circuits produced according to the same design having different relationships between voltage and frequency. Additionally, variations in circuit characteristics within an integrated circuit may result in different sections of the integrated circuit having different relationships between voltage and frequency. Temperature also affects the relationship between voltage and frequency. Furthermore, there may be drops in supply voltages that vary depending on the operations of various modules in the integrated circuit. Adaptive voltage scaling (AVS) can be used to control the supply voltage based on a sensed performance measure of the integrated circuit.

Device aging, particularly in nanometer technologies, results in changes in the electrical parameters of an integrated circuit. For example, transistor threshold voltages can be increased by effects such as positive bias temperature instability (PBTI) and negative bias temperature instability (NBTI). Circuits generally operate more slowly with aging. This further affects the relationship between supply voltage and clock frequency. The rate and amount of aging can vary with the usage of the integrated circuit. For example, a mobile phone may age more when the user uses the phone for multiple tasks such as texting, phone calls, streaming video, and playing games throughout the day compared to a user whose phone is in standby most of the day.

Prior aging compensation schemes estimate a priori the effect of aging on a device. Then, based on a worst-case scenario, effects of device aging are accounted for by including a large guard band so that the device meets its design requirements if the full effects of aging manifest themselves near the end of the expected operating life of the device. This results in a conservative design and can result in significant performance loss.
Attention is drawn to document US 2005/134394 A1 describing on-chip characterization of transistor degradation. It includes one or more functional blocks to perform one or more functions and an integrated on-chip characterization circuit to perform on-chip characterization of transistor degradation. The integrated on-chip characterization circuit includes a selectively enabled ring oscillator to generate a reference oscillating signal, a free-running ring oscillator to generate a free-running oscillating signal, and a comparison circuit coupled to the selectively enabled ring oscillator and the free-running ring oscillator. From the reference oscillating signal and the free-running oscillating signal, the comparison circuit determine a measure of transistor degradation.
Attention is further drawn to US 6 903 564 B1 describing a device aging determination circuit. Circuits are located on a device, including a first circuit operating at a first duty cycle and generating a first output and a second circuit operating at a second duty cycle different from said first duty cycle and generating a second output. A measuring circuit determines a difference in the first output and the second output, wherein the difference indicates an aging of the device. The aging is a representation of how much degradation the device has been exposed to, and allows for dynamic adjustment of operating parameters of the device to optimize performance.
Attention is further drawn to US 2011/090015 A1 describing a semiconductor integrated circuit that includes a first ring oscillator to which a stress voltage is applied; a second ring oscillator to which the stress voltage is not applied; and a phase comparator configured to receive an output of the first ring oscillator and an output of the second ring oscillator, and to compare phases of the outputs. The first ring oscillator includes a switch circuit configured to switch between a first connection state in which ring connection of the first ring oscillator is disconnected to connect a predetermined node of the second ring oscillator to a predetermined node of the first ring oscillator, and a second connection state in which connection between the first ring oscillator and the second ring oscillator is disconnected to connect the first ring oscillator in a ring. Attention is further drawn to US 2011/102064 A1 describing an aging detection circuit. An aging detection circuit may include at least an inverter and a half-latch. During a power-up sequence, if an input voltage of the first inverter changes sufficiently to cause the output of the inverter to change states, the output of the half-latch may be set to a state indicating aging of the circuit. This indication may be used in determining whether or not a supply voltage should be changed to compensate for the aging. A first transistor of the inverter may be arranged such that it remains active subsequent to power-up of the circuit. When active, the first transistor may be subject to degradation mechanisms associated with aging and which change its threshold voltage. The threshold voltage may change such that on a successive power-ups of the circuit, the first transistor is at least momentarily deactivated, leading to the setting of the state indicating aging by the half-latch circuit.
Attention is also drawn to US 2011/173432 A1 describing a processor-implemented method for determining aging of a processing unit in a processor, the method comprising: calculating an effective aging profile for the processing unit wherein the effective aging profile quantifies the effects of aging on the processing unit; combining the effective aging profile with process variation data, actual workload data and operating conditions data for the processing unit; and determining aging through an aging sensor of the processing unit using the effective aging profile, the process variation data, the actual workload data, architectural characteristics and redundancy data, and the operating conditions data for the processing unit.
Attention is further drawn to US 2006/223201 A1 describing on-chip transistor degradation detection and compensation. An integrated circuit is provided including a circuit with a body bias terminal coupled to a body of one or more transistors to receive a body bias voltage; a programmable degradation monitor to detect aging of transistors, and a body bias voltage generator coupled to the circuit and the programmable degradation monitor. The body bias voltage generator to adjust the body bias voltage coupled into the circuit in response to transistor aging detected by the programmable degradation monitor. The programmable degradation monitor includes a reference ring oscillator, an aged ring oscillator, and a comparison circuit. The comparison circuit to compare data delays in the reference ring oscillator and the aged ring oscillator to detect transistor aging within the integrated circuit.

### SUMMARY

In accordance with the present invention a circuit, as set forth in the independent claim, is provided. Preferred embodiments of the invention are described in the dependent claims.

In one aspect, a circuit for sensing aging of an integrated circuit is provided. The circuit includes: a first delay chain having a first input and a first output; a second delay chain having a second input and a second output; and a control module configured to place the first delay chain and the second delay chain in an aging state, an aged oscillating state, or a non-aged oscillating state.

A method is disclosed for de-aging an integrated circuit. The method includes: initializing operation of the integrated circuit with a safe voltage and frequency; enabling dynamic voltage and frequency scaling of the integrated circuit using initial values in a coefficient table containing target performance sensor measurement values for a plurality of operating frequencies; sensing aging of the integrated circuit; updating the coefficient table based on the sensed aging; and continuing dynamic voltage and frequency scaling using the updated coefficient table.

In one aspect, an integrated circuit is provided that includes: an aging sensor configured to sense aging of circuitry in the integrated circuit, wherein the aging sensor uses the same circuit to measure circuit speeds in both aged and un-aged condition; and a core power reduction controller module configured to control a supply voltage used in the integrated circuit, wherein the supply voltage is based at least in part on aging sensed by the aging sensor.

Further, an integrated circuit is disclosed that includes: means for sensing aging of circuitry in the integrated circuit using the same circuit to measure circuit speeds in both aged and un-aged condition; and a means for de-aging the integrated circuit configured to control a supply voltage used in the integrated circuit, wherein the supply voltage is based at least in part on aging sensed by the integrated circuit.

Other features and advantages of the present invention should be apparent from the following description which illustrates, by way of example, aspects of the invention.

### BRIEF DESCRIPTION OF THE DRAWINGS

The details of the present invention, both as to its structure and operation, may be gleaned in part by study of the accompanying drawings, in which like reference numerals refer to like parts, and in which:
FIG. 1 is a functional block diagram of an electronic system with dynamic de-aging according to a presently disclosed example;
FIG. 2 is a diagram illustrating layout of an integrated circuit with dynamic de-aging according to a presently disclosed example;
FIG. 3 is a functional block diagram of a performance sensor according to a presently disclosed example;
FIG. 4 is a schematic diagram of an aging sensor according to a presently disclosed embodiment;
FIG. 5 is a schematic diagram of a delay element according to a presently disclosed embodiment;
FIG. 6 is a schematic diagram of an aging sensor control module according to a presently disclosed embodiment;
FIGS. 7 and 8 are waveform diagrams illustrating operation of the aging sensor of FIG. 4; and
FIG. 9 is a flowchart of a process for dynamic de-aging according to a presently disclosed example.

### DETAILED DESCRIPTION

The detailed description set forth below, in connection with the accompanying drawings, is intended as a description of various configurations and is not intended to represent the only configurations in which the concepts described herein may be practiced. The detailed description includes specific details for the purpose of providing a thorough understanding of the various concepts. However, it will be apparent to those skilled in the art that these concepts may be practiced without these specific details. In some instances, well-known structures and components are shown in simplified form in order to avoid obscuring such concepts.

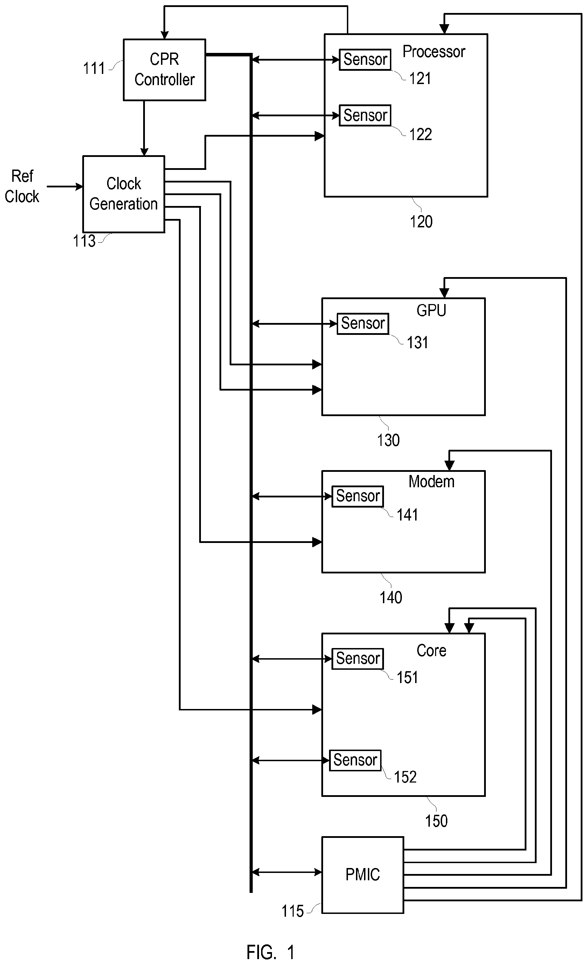

FIG. 1 is a functional block diagram of an electronic system with dynamic de-aging according to a presently disclosed example. The system may be implemented using one or multiple integrated circuits. The system may be used, for example, in a mobile phone.

The system includes various modules that perform operational functions for the system. The term operation is used to distinguish functions that may be considered to provide the primary utility of the electronic system from those functions that may be considered ancillary. The example system illustrated in FIG. 1 includes a processor module 120, a graphics processing unit (GPU) 130, a modem module 140, and a core module 150. The processor module 120 can provide general programmable functions; the graphics processing unit 130 can provide graphics functions; the modem module 140 can provide communications functions, for example, wireless communications according to long term evolution (LTE) or code division multiple access (CDMA) protocols; and the core module 150 can provide various functions that are not provided by the other modules.

A clock generation module 113 receives a reference clock input and supplies one or more clock signals to the other modules. The clock generation module 113 may include phase locked loops and dividers to supply the clock signals at various frequencies. The clock generation module 113 supplies the clocks to the other modules at frequencies controlled by a core power reduction (CPR) controller module 111. All or parts of the functions of the clock generation module 113 may be located in the various modules that use the clock signals.

A power management integrated circuit (PMIC) 115 supplies one or more voltages to the other modules in the system. The PMIC 115 may include switching voltage regulators and low-dropout regulators. The PMIC 115 may be a separate integrated circuit. The voltages supplied by the PMIC 115 are also controlled by the core power reduction controller module 111. Modules of the systems may have one voltage supply or multiple voltages supplies and multiple modules may operate with a common voltage supply.

The processor module 120, the graphics processing unit 130, the modem module 140, and the core module 150 include performance sensors. In the example system of FIG. 1, the processor module 120 includes two performance sensors 121, 122; the graphics processing unit 130 includes a performance sensor 131; the modem module 140 includes a performance sensor 141; and the core module 150 includes two performance sensors 151, 152. Each of the performance sensors includes circuitry to measure circuit speed. For example, the performance sensors may count oscillations of ring oscillators. Each performance sensor also includes an aging sensor. The aging sensor measures the effect of aging on circuit performance. The performance sensors measure performance characteristics of circuitry in the sensor. Although the performance of circuitry in an integrated circuit may vary with location, temperature, voltage drop, and other parameters, performance measured by a performance sensor can be used to estimate performance of similar circuitry near the performance sensor. The aging sensor, in an embodiment, uses the same circuit to measure circuit speeds in both aged and un-aged conditions.

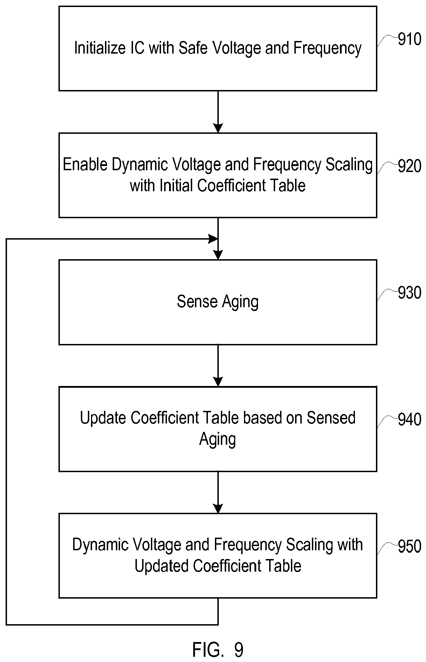

The core power reduction controller module 111 controls the clock frequencies and the supply voltages used by the modules in the system. The core power reduction controller module 111 may, for example, control the frequencies and voltages based on an operating mode selected by the processor module 120. In an example, the processor selects operating frequencies and the core power reduction controller module 111 determines the supply voltage. The core power reduction controller module 111 can determine the supply voltages based on performance measurements from the performance sensors in the corresponding modules and based on aging from the aging sensors. The core power reduction controller module 111 may determine a supply voltage so that it equals or only slightly (e.g., 10 mV) exceeds the minimum voltage needed for a selected operating frequency. In other examples, the core power reduction controller module 111 may control just the clock frequencies. The system may, alternatively or additionally, control other parameters, such as substrate voltage, that affect performance. Example functions of the core power reduction controller module 111 will be further described with reference to the process illustrated in FIG. 9.

Prior systems that do not include dynamic de-aging set the supply voltage to a value that substantially exceeds the minimum voltage needed by a guard band amount. The guard band amount (for example, 100 mV) is used to compensate for, among other things, the effect of aging (whose magnitude at any given time is not known). In prior systems, the amount of guard banding for aging is fixed and applied even at the beginning of operation of the system when no aging has occurred. Guard banding has also been used with other parameters, such as clock frequency. The de-aging systems and methods described herein eliminate or reduce the performance loss for guard banding.

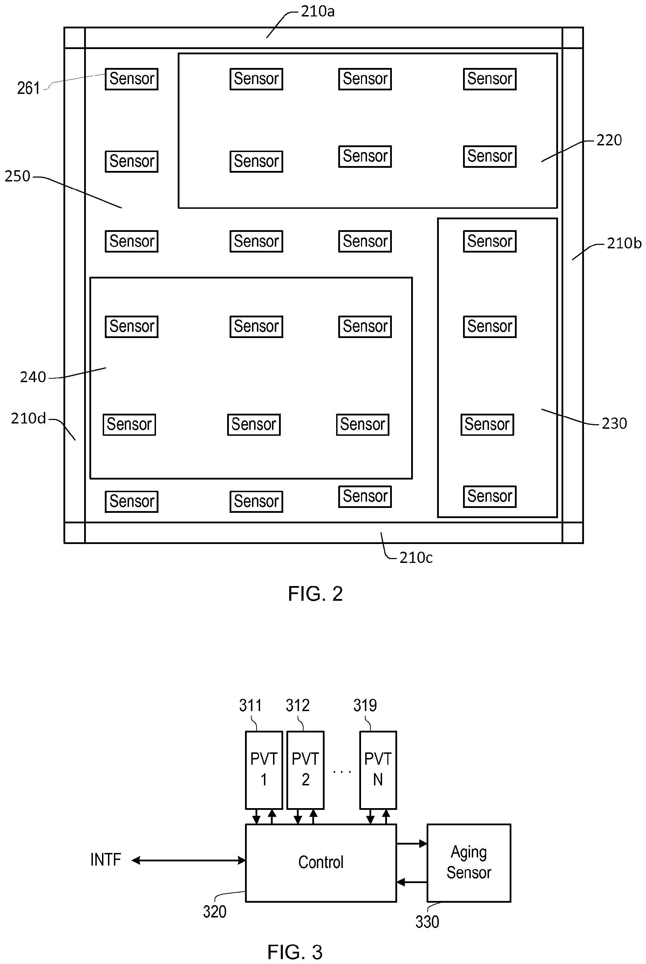

FIG. 2 is a diagram illustrating layout of an integrated circuit with dynamic de-aging according to a presently disclosed example. The integrated circuit may be used to implement the electronic system of FIG. 1. The integrated circuit may be, for example, fabricated using a complementary metal-oxide-semiconductor (CMOS) process.

The integrated circuit of FIG. 2 includes four periphery blocks 210 (210a, 210b, 210c, and 210d) located along the edges of the integrated circuit. The integrated circuit includes a processor module 220, a graphics processing module 230, and a modem module 240 that are large blocks internal to the integrated circuit. Other functions of the integrated circuit, such as those provided by the core module 150 in the system of FIG. 1, may be spread throughout remaining areas 250 of the integrated circuit. The core power reduction controller module 111 of FIG. 1 may also be implemented in the remaining areas 250 of the integrated circuit.

The integrated circuit also includes performance sensors 261 that are spaced throughout the integrated circuit area. Although FIG. 2 illustrates twenty performance sensors, an integrated circuit implementation may include hundreds of performance sensors. The performance sensors may be, for example, serially connected to the core power reduction controller module 111 or may be connected by a bus.

FIG. 3 is a functional block diagram of a performance sensor according to a presently disclosed example. The performance sensor may be used to implement the performance sensors 121, 122, 131, 141, 151, 152 of FIG. 1 and the performance sensors 261 of FIG. 2.

The performance sensor of FIG. 3 includes multiple PVT sensors 311-319. Each of the PVT sensors 311-319 measures a circuit performance, for example, by operating a ring oscillator to produce an output whose frequency is indicative of the circuit performance. Different ones of the PVT sensors 311-319 sensors may measure performance of different types of circuits, for example, circuits with different type of transistors. The name PVT refers to process, voltage, and temperature, which are major influences on circuit performance.

The performance sensor includes an aging sensor 330. The aging sensor 330 can measure the effect of circuit aging. The aging sensor 330 includes delay lines that can be controlled (e.g., by the core power reduction controller module 111) to be in an aging state, an aged oscillating state, or a non-aged oscillating state. In an example embodiment, in the aging state, the delay lines are held in a static powered state. The delay lines are powered with the same supply voltage used by the circuit whose aging is to be sensed by the aging sensor. In the aged oscillating state, the delay lines are coupled to produce a clock output that oscillates at a frequency based on delays of aged circuitry. In the non-aged oscillating state, the delay lines are coupled to produce a clock output that oscillates at a frequency based on delays of non-aged circuitry. The same transistors are used in both the aged oscillating state and the non-aged oscillating state.

The performance sensor includes a control module 320. The control module 320 provides an interface to other modules, for example, to the core power reduction controller module 111 to communicate sensed performance measurements. The control module 320 may also include counters to count oscillations of the PVT sensors 311-319 and the aging sensor 330. The counters can count for a known time interval to measure frequencies of oscillators in the PVT sensors 311-319 or the aging sensor 330. The control module 320 may cause the voltage supply to the PVT sensors 311-319 to be removed when the PVT sensors 311-319 are not performing measurements. The aging sensor 330, however, remains powered during the aging state.

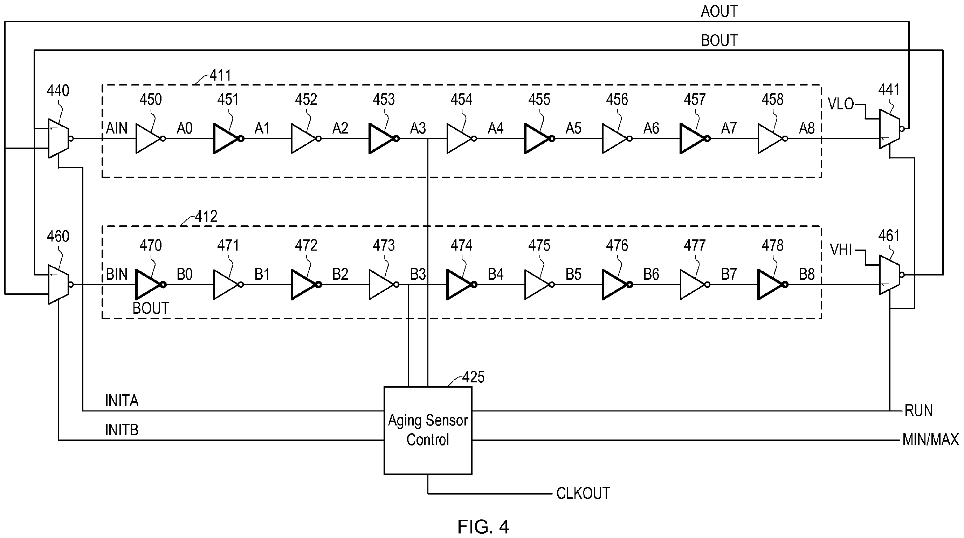

FIG. 4 is a schematic diagram of an aging sensor according to a presently disclosed embodiment. The aging sensor may implement the aging sensor 330 of FIG. 3, which can be used in the system of FIG. 1 and the integrated circuit of FIG. 2.

The aging sensor of FIG. 4 includes a first delay chain 411 and a second delay chain 412. The first delay chain 411 receives a first input AIN and produces a first output A8. The second delay chain 412 receives a second input BIN and produces a second output B8. Each delay chain includes a chain of delay elements (delay elements 450-458 in the first delay chain 411 and delay elements 470-478 in the second delay chain 412). In the illustrated embodiment, each delay chain includes nine delay elements and the delay elements are inverters.

The aging sensor includes an aging sensor control module 425 that controls functions of the aging sensor. The aging sensor control module 425 also produces a clock output (CLKOUT) that can indicate performance of both aged circuits and non-aged circuits. The aging sensor control module 425 receives a run control input (RUN). When the run control input is low, the aging sensor is not running (aging state) and the delay chains (also referred to as delay lines) are held in a particular state to age the delay elements. When the run control input is high, the delay chains are coupled to form a ring oscillator whose frequency is slowed by aging (aged oscillating state) or coupled to form a ring oscillator whose frequency is not slowed by aging (non-aged oscillating state). Selection of the aged oscillating state or non-aged oscillating state is controlled by a MIN/MAX control input.

In the embodiment illustrated in FIG. 4, four multiplexers are used to place the delay chains in the aging state, the aged oscillating state, or the non-aged oscillating state. In the aging sensor of FIG. 4, the multiplexers are inverting from input to output. Other embodiments may use non-inverting multiplexers.

Multiplexer 441 selects between the output (A8) of the first delay chain (when in the run state) and a static low voltage (when not in the run state). Multiplexer 461 selects between the output (B8) of the second delay chain (when in the run state) and a static high voltage (when not in the run state).

Multiplexer 440 selects between the output (AOUT) of multiplexer 441 and the output (BOUT) of multiplexer 461 to supply the input (AIN) of the first delay chain 411. Multiplexer 460 selects between the output (AOUT) of multiplexer 441 and the output (BOUT) of multiplexer 461 to supply the input (BIN) of the second delay chain 412. The selection performed by multiplexer 440 is controlled by a first control signal (INITA) supplied by the aging sensor control module 425, and the selection performed by multiplexer 460 is controlled by a second control signal (INITB) supplied by the aging sensor control module 425.

In the aging state, the input of the first delay chain 411 has a first logic value and the input to the second delay chain 412 has a second logic vale that is the complement of the first logic value. In the embodiment of FIG. 4, the first logic value is high and the second logic value is low.

In the aging state, multiplexer 441 selects the low voltage input and AOUT is high and multiplexer 461 selects the high voltage input and BOUT is low. The aging sensor control module 425 produces the first control signal (INITA) to be high. Thus, multiplexer 440 selects BOUT (which is low) and the multiplexer output (AIN) is high. The aging sensor control module 425 produces the second control signal (INITB) to be low. Thus, multiplexer 460 selects AOUT (which is high) and the multiplexer output (BIN) is low. This results in the first delay chain 411 and the second delay chain 412 being held in complementary states with alternating delay elements having complementary outputs. In detail, in the first delay chain 411, the output (A0) of the first delay element 450 is low, the output (A1) of the second delay element 451 is high, the output (A2) of the third delay element 452 is low, and so on through to the output (A8) of the ninth delay element 458 being low. And in the second delay chain 412, the output (B0) of the first delay element 470 is high, the output (B1) of the second delay element 471 is low, the output (B2) of the third delay element 472 is high, and so on through to the output (B8) of the ninth delay element 478 being high.

The static voltages on the delay elements tend to age the delay elements so that transitions into the aged states are slowed. For example, the output (A0) of the first delay element 450 was low during aging and falling transitions on that output will be slowed by aging effects. Similarly, the output (A1) of the second delay element 451 was high during aging and rising transitions on that output will be slowed by aging effects. Since rising and falling transitions alternate from delay element to delay element and the transitions that are affected by aging also alternate from delay element to delay element, the entire delay chain is affected by aging for the same transition on the input to the delay chain. The first delay chain 411 is slowed by aging for rising transitions on its input. Similarly, the second delay chain 412 is slowed by aging for falling transitions on its input.

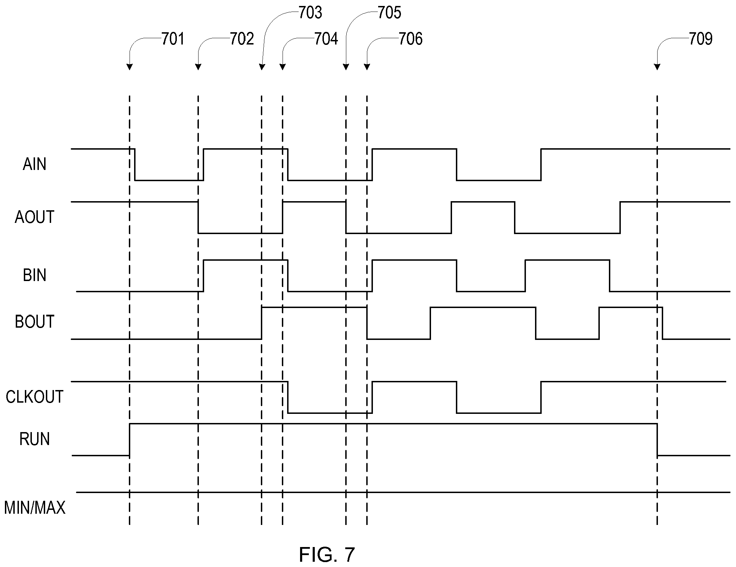

In the aged oscillating state, the aging sensor control module 425 controls the first and second control signals so that the delay chains oscillate with a period that includes the delay of the first delay chain 411 for rising transitions on its input and the delay of the second delay chain for falling transitions on its input. Operation in the aged oscillating state is illustrated in the waveform diagram of FIG. 7. At the beginning of the waveforms, the run control input RUN is low and the delay chains are in the aging state with the input (AIN) to the first delay chain high and the input (BIN) to the second delay chain low.

At time 701, the run control input switches high and the MIN/MAX control input is high so that the aging sensor enters the aged oscillating state. The first control signal (INITA) switches high so that multiplexer 440 switches and the input (AIN) to the first delay chain 411 switches low. The falling transition on the input to the first delay chain 411 propagates through the delay chain and through multiplexer 441 to AOUT, which falls at time 702. At this time, the first and second control signals from the aging sensor control module 425 are both low so that AOUT is selected and the inputs to both delay chains rise (the falling of AOUT inverted by multiplexer 440 and multiplexer 460).

The rising transitions on the inputs to the delay chains propagate through both delay chains concurrently. Delays in the first delay chain 411 for a rising transition on its input are slowed by aging. Delays in the second delay chain 412 for a rising transition on its input are not slowed by aging. The rise on the input to the second delay chain 412 propagates through to its output at time 703 and the rise on the input to the first delay chain 411 propagates through to its output at time 704. The difference between time 704 and time 703 is the effect of aging. In FIG. 7, the difference in delay is exaggerated to clearly illustrate the effect.

Before time 703, the first and second control signals from the aging sensor control module 425 are set so that multiplexer 440 and multiplexer 460 select AOUT (from the delay chain affected by aging for a rising input). Thus, the inputs to both delay chains fall (the rising of AOUT inverted by multiplexer 440 and multiplexer 460) after time 704.

The rising transitions on the inputs to the delay chains propagate through both delay chains concurrently. Delays in the first delay chain 411 for a falling transition on its input are not slowed by aging. Delays in the second delay chain 412 for a falling transition on its input are slowed by aging. The fall on the input to the first delay chain 411 propagates through to its output at time 705 and the fall on the input to the second delay chain 412 propagates through to its output at time 706. The difference between time 706 and time 705 is the effect of aging.

Before time 705 the first and second control signals from the aging sensor control module 425 are set so that multiplexer 440 and multiplexer 460 select BOUT (from the delay chain affected by aging for a falling input). Thus, the inputs to both delay chains rise and one oscillation of the delay chains is completed. The sequence of signal transitions then repeats as described beginning from time 702.

At time 709, the run control input switches low and the aging sensor switches back to the aging state. The aged oscillating state in FIG. 7 lasts only a few oscillations, but in an integrated circuit, the aged oscillating state may last, for example, hundreds or thousands of oscillations.

The aging sensor control module 425 can time transitions on its control signals to multiplexer 440 and multiplexer 460 using signals from midpoints of the delay chains. For example, the outputs (A3, B3) of the fourth delay elements in each delay chain may be logically NANDed it to produce the clock output CLKOUT. The clock output may then be used to generate the control signals (INITA, INITB).

In the aged oscillating state (from time 701 to time 709), the period of the clock output combines the delay of the first delay chain for rising transitions on its input and the delay of the second delay chain for falling transitions on its input. Each of these cases is slowed by aging so that the frequency of oscillation can be used to measure the amount of aging that has occurred.

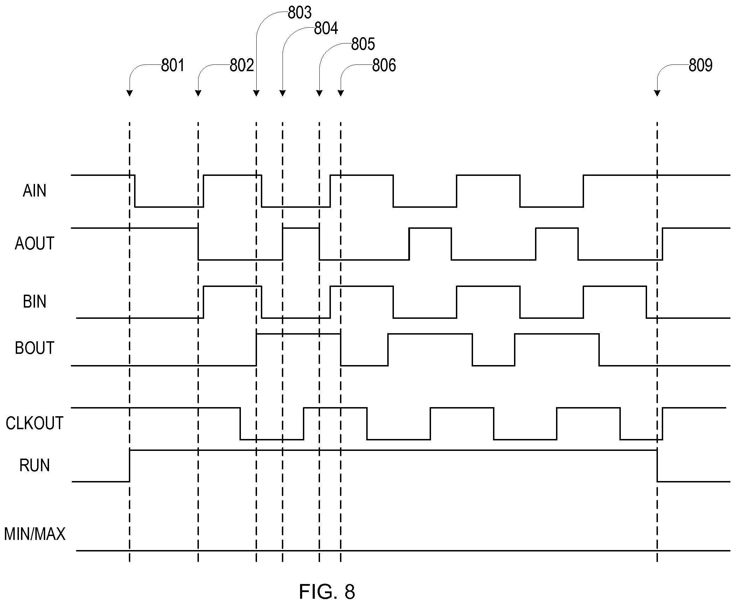

In the non-aged oscillating state, the aging sensor control module 425 controls the first and second control signals so that the delay chains oscillate with a period that includes the delay of the first delay chain 411 for falling transitions on its input and the delay of the second delay chain for rising transitions on its input. Operation in the non-aged oscillating state is illustrated in the waveform diagram of FIG. 8. At the beginning of the waveforms, the run control input RUN is low and the delay chains are in the aging state with the input (AIN) to the first delay chain high and the input (BIN) to the second delay chain low.

At time 801, the run signal switches high and the MIN/MAX control signal is low so that the aging sensor enters the non-aged oscillating state. The first control signal (INITA) switches low so that multiplexer 440 switches and the input (AIN) to the first delay chain 411 switches low. The falling transition on the input to the first delay chain 411 propagates through the delay chain and through multiplexer 441 to AOUT, which falls at time 802. At this time, the first and second control signals from the aging sensor control module 425 are both low so that AOUT is selected and the inputs to both delay chains rise (the falling of AOUT inverted by multiplexer 440 and multiplexer 460).

The rising transitions on the inputs to the delay chains propagate through both delay chains concurrently. Delays in the first delay chain 411 for a rising transition on its input are slowed by aging. Delays in the second delay chain 412 for a rising transition on its input are not slowed by aging. The rise on the input to the second delay chain 412 propagates through to its output at time 803 and the rise on the input to the first delay chain 411 propagates through to its output at time 804. The difference between time 804 and time 803 is the effect of aging. In FIG. 8, the difference in delay is exaggerated to clearly illustrate the effect.

Before time 803 the control signals from the aging sensor control module 425 are set so that multiplexer 440 and multiplexer 460 select BOUT (from the delay chain not affected by aging for a rising input). Thus, the inputs to both delay chains fall (the rising of AOUT inverted by multiplexer 440 and multiplexer 460) after time 803.

The rising transitions on the inputs to the delay chains propagate through both delay lines concurrently. Delays in the first delay chain 411 for a falling transition on its input are not slowed by aging. Delays in the second delay chain 412 for a falling transition on its input are slowed by aging. The fall on the input to the first delay chain 411 propagates through to its output at time 805 and the fall on the input to the second delay chain 412 propagates through to its output at time 806. The difference between time 806 and time 805 is the effect of aging.

Before time 805 the control signals from the aging sensor control module 425 are set so that multiplexer 440 and multiplexer 460 select AOUT (from the delay chain not affected by aging for a falling input). Thus, the inputs to both delay chains rise and one oscillation of the delay chains is completed. The sequence of signal transitions then repeats as described beginning from time 802.

At time 809, the run control input switches low and the aging sensor switches back to the aging state. The non-aged oscillating state in FIG. 8 lasts only a few oscillations, but in an integrated circuit the aged oscillating state may last, for example, hundreds or thousands of oscillations.

The aging sensor control module 425 can time transitions on its control signals to multiplexer 440 and multiplexer 460 using signals from midpoints of the delay chains as described from the aged oscillating state.

In the non-aged oscillating state (from time 801 to time 809), the period of the clock output combines the delay of the first delay chain for falling transitions on its input and the delay of the second delay chain for rising transitions on its input. Each of these cases is not slowed by aging so that the frequency of oscillation can be used to indicate the amount of aging that has occurred. In some cases, the effect of aging may increase the frequency of oscillation in the non-aged oscillating state.

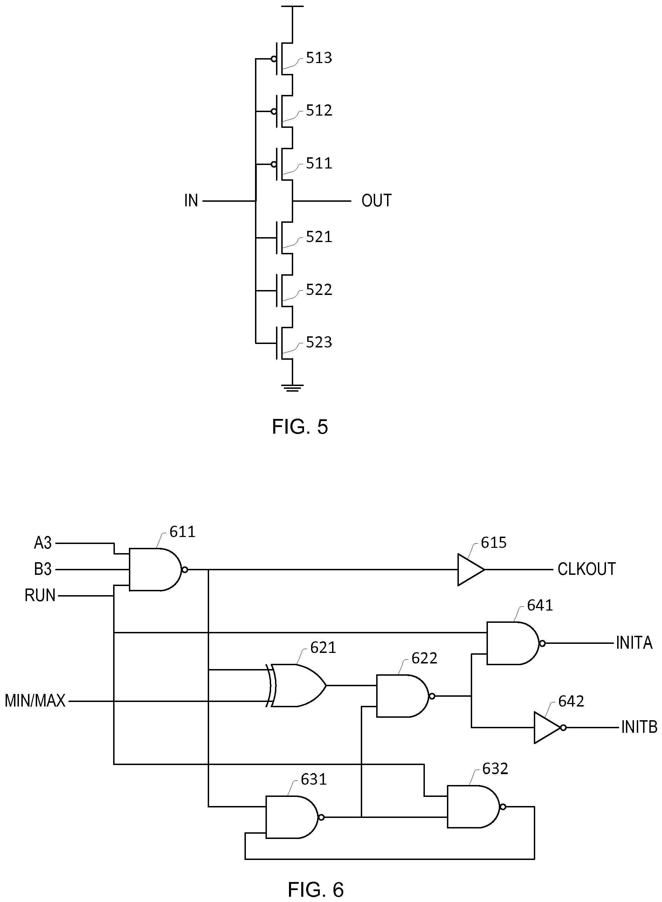

FIG. 5 is a schematic diagram of a delay element according to a presently disclosed embodiment. The delay element may be used to implement the delay elements in the delay chains of the aging sensor of FIG. 4. The delay element of FIG. 5 receives an input (IN) and produces an inverted output (OUT).

The delay element is an inverter that includes three p-channel transistors 511, 512, 513 whose sources and drains are connected in series between a voltage supply and the output. The gates of the p-channel transistors 511, 512, 513 connect to the input. The delay element includes three n-channel transistors 521, 522, 523 whose sources and drains connected in series between a ground reference and the output. The gates of the n-channel transistors 521, 522, 523 connect to the input. The use of transistors in series can increase the delay of the delay element so that the delay chains in the aging sensor can have fewer stages. Many other types of delay elements may also be used, for example, depending upon particular aging effects of interest.

FIG. 6 is a schematic diagram of an aging sensor control module according to a presently disclosed embodiment. The aging sensor control module may be used to implement the aging sensor control module 425 of the aging sensor of FIG. 4. The circuit illustrated in FIG. 6 is exemplary and the same or similar functions may be implemented in other ways.

The aging sensor control module uses NAND gate 611 and buffer 615 to produce the clock output from midpoints (A3, B3) of the delay chains and the run control input (RUN). NAND gate 631 and NAND gate 632 form a set-reset latch that is initialized when the run control input is low and toggled when the clock output rises. The output of NAND gate 631 will be low while the run control input is low (in the aging state) and will then transition high on the first falling edge of the clock output.

Exclusive-OR gate 621 is used to toggle the control signals (INITA, INITB) based on the clock output with their polarity determined by the MIN/MAX control input. The beginning of transitions (after the rise of the run control signal) on the control signals is enabled by NAND gate 622. The first control signal (INITA) is buffered by NAND gate 641 which also controls the value of the first control signal during the aging state (when the run control input is low). The second control signal (INITB) is buffered by inverter 642.

FIG. 9 is a flowchart of a process for dynamic de-aging according to a presently disclosed example. The process may be performed, for example, by the core power reduction controller module 111 in the electronic system of FIG. 1.

The process uses an aging sensor, for example, the aging sensor of FIG. 4. The frequency of oscillation in the aged oscillating state (F_{aged}) and the frequency of oscillation in the non-aged oscillating state (F_{non-aged}) are measured and used to de-age (compensate for aging) operation of an associated circuit. The sensors may be referred to in shorthand as ring oscillators or ROs. The process uses a determined relationship between aging measured by the aging sensor and aging of an operational circuit so that the measured aging in the aging sensor can be used to compensate for aging of the operational circuit. The process will be described in more detail for one domain (an operational circuit module with a common supply voltage), but it should be understood that the process can be used for multiple domains that can each operate at multiple frequencies.

The relationship between aging measured by the aging sensor and aging of an operational circuit can be determined by characterization testing of actual integrated circuits. For example, the integrated circuits may be operated at various temperatures, frequencies, and voltages and the performance of the aging sensors and performance of the operational modules of the integrated circuit measured over time.

Concepts and variables that are used in the dynamic de-aging process or in the description of the process are defined below.

Aging RO Degradation (ARD) reflects the degradation due to aging of the ring oscillators in the aging sensor. ARD expresses the sensor aging as a percentage change in sensor oscillating frequency due to aging. In an example, ARD = (F_{non-aged} - F_{aged}) / F_{non-aged} + AED in percent. F_{non-aged} is the frequency of the aging sensor in the non-aged oscillating state, which is not sensitive to transistor aging; F_{aged} is the frequency of the aging sensor in the aged oscillating state, which is sensitive to aging and will gradually slow down as the transistors degrade. Therefore, ARD will gradually increase as transistors age. For a domain having multiple aging sensors, ARD is the maximum measurement value from all the aging sensors in the domain. ARD should be >= 0. This can be achieved using AED to offset negative values. Alternatively or additionally, the process may set negative ARD values to 0. ARD can be voltage dependent: ARD generally increases as measurement voltage decreases.

Aging Error Distribution (AED) indicates the systematic random variation in the measurements of ARD at time 0 (before aging). Ideally, ARD (at time=0) should be 0, but ARD may be a small random value with a distribution centered on 0. Because ARD is the largest measured value from all of the aging sensors in a domain, it is very likely that ARD (at time=0) is >=0, instead of negative. ARD >=0 at time 0 is fine, but if ARD <0 at time 0, AED is used to guard band ARD. If during product characterization at time=0, the ARD of a domain is negative, then its worst case absolute value will set the AED value.

Aging Scaling Ratio (ASR) indicates the relationship between sensor aging and aging of operational circuits in the associated domain. The aging of operational circuits can be expressed as the change in the maximum operating frequency (Fₘₐₓ) of those circuits. The process can set ASR = Fₘₐₓ Degradation / ARD. Fₘₐₓ Degradation is the amount of change in the maximum operating frequency of the circuits in a domain for particular conditions. The unit level ASR value can be collected from the product high-temperature operating life (HTOL) test units with the worst readout value (of multiple readouts made over the HTOL test) used as the ASR value for circuits in a given domain. One ASR value can be determined from multiple readouts during the product HTOL test. Alternatively, multiple ASR values may be used, for example, in a derating table.

A voltage to frequency scaling factor indicates the relationship between voltage and maximum operating frequency of an operational circuit. The voltage to frequency scaling factor may be expressed as a Voltage of Percent Fₘₐₓ (VPF) indicating the amount of voltage increase needed to deliver a 1% Fₘₐₓ increase in a domain. VPF can be determined from product characterization. The highest VPF value measured for a given domain should be used. VPF may be voltage dependent. The voltages can be divided into ranges with multiple VPF values used or a highest VPF value used for all voltages.

Aging Guard Band (AGB) is the amount of voltage increase needed to compensate transistor degradation to maintain the Fₘₐₓ for circuits of a domain. The process can set AGB = VPF * ASR * ARD. AGB can be updated after each ARD measurement. AGB could be voltage dependent. The process can use multiple AGB values for different ranges of voltages or may scale one AGB value for use at other voltages.

Aging Target Addon (ATA) is a value, converted from AGB, that the process can use to update a coefficient table that indicates what performance sensor measurement values are needed for associated operational modules to operate at various frequencies. This conversion maps the AGB values (which indicate an amount of aging compensation in voltage) to target performance sensor values. This mapping can use, for example, a relationship between supply voltage and performance sensor measurements obtaining from an integrated circuit characterization. The ATA values update the coefficient table values to compensate aging degradation. For example, a coefficient table value that indicates a particular performance sensor measurement value that is needed for an associated operation module to operate at a particular frequency can be increased. In a system that does not use the coefficient table described above, translation of ATA values may be omitted or replaced with other calculations appropriate for that system.

The process of FIG. 9 illustrates how an integrated circuit may be operated using the above de-aging information. For clear explanation, the process is described for a single domain but it should be understood that the process can be used for de-aging of multiple domains.

In block 910, the integrated circuit is initialized with safe voltages and frequencies. This combination of voltages and frequencies has sufficient guard band for reliable operation of the integrated circuit under all expected conditions. The expected conditions may include all conditions for which the integrated circuit is specified to operate. The safe voltages and frequencies allow reliable operation of the integrated circuit for the worst-case aging.

In block 920, the process enables dynamic voltage and frequency scaling in the integrated circuit using initial values in a coefficient table. The coefficient table contains target performance sensor measurement values for various operating frequencies. An example of a dynamic voltage and frequency scaling operation includes measuring performance to obtain a performance sensor measurement, looking up the current operating frequency in the correction table to obtain the corresponding target performance sensor measurement value, and conditionally adjusting the voltage based on the relative values of the performance sensor measurement and the target value. If for example, the performance sensor measurement is less than the target value, the voltage may be raised to increase circuit speeds. The initial values in the coefficient table include sufficient guard banding for end-of-life (EOL) aging of the integrated circuit. The initial values may be determined by characterization of the integrated circuit. The guard banding for end-of-life aging may be effected by using an initial ATA value. The process then continues to perform de-aging based on sensed aging.

In block 930, the process measures aging of the integrated circuit. Block 930 can include measuring ARD according to ARD = (F_{non-aged} - F_{aged})/ F_{non-aged} + AED. In an embodiment, F_{aged} is measure before F_{non-aged}. This can avoid or minimize reversal of effects of aging that may occur when the aging sensor oscillates to perform the measurements. The process can then calculate AGB according to AGB = VPF * ASR * ARD. AGB is calculated in the normal (non-standby) mode. The process can then calculate ATA to replace the initial (or current) ATA. In an example, the process limits the amount of ATA to a maximum end-of-life value, which may be determined by characterization of the integrated circuit. In various examples, ARD may be measured at a fixed voltage or at currently used operating voltages associated with the aging sensors.

In block 940, the process updates the coefficient table based on the aging sensed in block 930. A process can update the coefficient table for one frequency, all frequencies, or a range of frequencies. Alternatively, the process may update the coefficient table before enabling dynamic voltage and frequency scaling. In another alternative, update the coefficient table for the initialized operating frequency, enables dynamic voltage and frequency scaling, and then updates the full coefficient table.

In block 950, the integrated circuit operates using dynamic voltage and frequency scaling with the updated coefficient table from block 940.

Periodically, the process returns to blocks 930 and 940 to further update the coefficient table for the effects of aging. The process may update the coefficient table based on expiration of a timer. The period of the updates may be, for example, one minute, 10 minutes, or hourly. The period between updates may change over time, for example, with less frequent updates as the integrated circuit ages. Additionally or alternatively, the process may update the coefficient table based on a change in operational mode of the integrated circuit or an operational module of the integrated circuit. For example, the coefficient table may be updated when the integrated circuit switches from an operating mode to a standby mode or vice versa.

The process for dynamic de-aging may be modified, for example, by adding, omitting, reordering, or altering blocks. For example, the process may de-age by adjusting clock frequencies (or other performance parameters). In such an example, the process may omit the calculations using the voltage to frequency scaling factor. Additionally, blocks may be performed concurrently.

Although embodiments of the invention are described above for particular embodiments, many variations of the invention are possible. For example, the numbers of various components may be increased or decreased. The described systems and methods may be modified depending upon the particular aging effects that are most important in an integrated circuit. The aging sensor may be tailored according to the specific fabrication technology of an integrated circuit. An integrated circuit may contain multiple aging sensors to measure multiple aging effects. Additionally, features of the various embodiments may be combined in combinations that differ from those described above.

Those of skill will appreciate that the various illustrative blocks and modules described in connection with the embodiments disclosed herein can be implemented in various forms. Some blocks and modules have been described above generally in terms of their functionality. How such functionality is implemented depends upon the design constraints imposed on an overall system. Skilled persons can implement the described functionality in varying ways for each particular application, but such implementation decisions should not be interpreted as causing a departure from the scope of the invention. In addition, the grouping of functions within a module or block is for ease of description. Specific functions can be moved from one module or block or distributed across to modules or blocks without departing from the invention.

The various illustrative logical blocks and modules described in connection with the embodiments disclosed herein can be implemented or performed with a general purpose processor, a digital signal processor (DSP), application specific integrated circuit (ASIC), a field programmable gate array (FPGA) or other programmable logic device, discrete gate or transistor logic, discrete hardware components, or any combination thereof designed to perform the functions described herein. A general-purpose processor can be a microprocessor, but in the alternative, the processor can be any processor, controller, microcontroller, or state machine. A processor can also be implemented as a combination of computing devices, for example, a combination of a DSP and a microprocessor, a plurality of microprocessors, one or more microprocessors in conjunction with a DSP core, or any other such configuration.

The steps of a method or algorithm described in connection with the embodiments disclosed herein can be embodied directly in hardware, in a software module executed by a processor, or in a combination of the two. A software module can reside in RAM memory, flash memory, ROM memory, EPROM memory, EEPROM memory, registers, hard disk, a removable disk, a CD-ROM, or any other form of storage medium. An exemplary storage medium can be coupled to the processor such that the processor can read information from, and write information to, the storage medium. In the alternative, the storage medium can be integral to the processor. The processor and the storage medium can reside in an ASIC.

The above description of the disclosed embodiments is provided to enable any person skilled in the art to make or use the invention. Various modifications to these embodiments will be readily apparent to those skilled in the art, and the generic principles described herein can be applied to other embodiments without departing from the scope of the invention. Thus, it is to be understood that the description and drawings presented herein represent a presently preferred embodiment of the invention and are therefore representative of the subject matter which is broadly contemplated by the present invention. It is further understood that the scope of the present invention fully encompasses other embodiments that may become obvious to those skilled in the art and that the scope of the present invention is accordingly limited by nothing other than the appended claims.

## Claims

1. A circuit for sensing aging of an integrated circuit, comprising:
a first delay chain (411) having a first input and a first output;
a second delay chain (412) having a second input and a second output; and
a control module (425) configured to place the first delay chain and the second delay chain in either an aging state in which circuitry in the first and second delay chains ages, an aged oscillating state in which the first delay chain is coupled with the second delay chain to produce a clock output oscillating at a frequency based on delays of aged circuitry, or a non-aged oscillating state in which the first delay chain is coupled with the second delay chain to produce the clock output oscillating at a frequency based on delays of non-aged circuitry;
wherein the aging state includes supplying an operating voltage to the first delay chain and the second delay chain;
wherein the aging state further includes supplying a first logic value to the first input and a second logic value to the second input, wherein the first logic value is the complement of the second logic value;
wherein the aged oscillating state includes selecting between the first output and second output and coupling the selected signal to the first input and the second input and wherein the first output is selected after the first input transitions to the first logic value and the second output is selected after the second input transitions to the second logic value;
wherein the non-aged oscillating state includes selecting between the first output and second output and coupling the selected signal to the first input and the second input and wherein the first output is selected after the first input transitions to the second logic value and the second output is selected after the second input transitions to the first logic value.

2. The circuit of claim 1, wherein the first delay chain includes a first chain of delay elements coupled between the first input and the first output, and the second delay chain includes a second chain of delay elements coupled between the second input and the second output.

3. The circuit of claim 2, wherein each of the delay elements includes an inverter.

4. The circuit of claim 3, wherein each inverter includes a plurality of p-channel transistors in series and a plurality of n-channel transistors in series.

5. The circuit of claim 1, wherein the period of the oscillations of the clock output in the aged oscillating state includes a combination of a delay for a rising transition through the first delay chain that is slowed by aging and a delay for a falling transition through the second delay chain that is slowed by aging.

6. The circuit of claim 1, wherein the period of the oscillations of the clock output in the non-aged oscillating state includes a combination of a delay for a falling transition through the first delay chain that is not slowed by aging and a delay for a rising transition through the second delay chain that is not slowed by aging.

## Patentansprüche

1. Ein Verfahren zum Abfühlen einer Alterung einer integrierten Schaltung, das Folgendes aufweist:
eine erste Verzögerungskette (411) mit einem ersten Eingang und einem ersten Ausgang;
eine zweite Verzögerungskette (412) mit einem zweiten Eingang und einem zweiten Ausgang; und
ein Steuermodul (425), das konfiguriert ist zum Setzen der ersten Verzögerungskette und der zweiten Verzögerungskette in entweder einen Alterungszustand, in dem Schaltkreise in den ersten und zweiten Verzögerungsketten altern, einen gealterten oszillierenden Zustand, in dem die erste Verzögerungskette mit der zweiten Verzögerungskette gekoppelt ist zum Erzeugen einer Taktausgabe, die bei einer Frequenz oszilliert, basierend auf Verzögerungen gealterter Schaltkreise, oder einen nicht gealterten oszillierenden Zustand, in dem die erste Verzögerungskette mit der zweiten Verzögerungskette gekoppelt ist zum Erzeugen der Taktausgabe, die bei einer Frequenz oszilliert basierend auf Verzögerungen nicht gealterter Schaltkreise;
wobei der Alterungszustand Liefern einer Betriebsspannung an die erste Verzögerungskette und die zweite Verzögerungskette beinhaltet;
wobei der Alterungszustand weiter Liefern eines ersten Logikwertes an den ersten Eingang und eines zweiten Logikwertes an den zweiten Eingang aufweist, wobei der erste Logikwert das Komplement des zweiten Logikwertes ist;
wobei der gealterte oszillierende Zustand Auswählen zwischen dem ersten Ausgang und dem zweiten Ausgang aufweist und Koppeln des ausgewählten Signals an den ersten Eingang und den zweiten Eingang und wobei der erste Ausgang ausgewählt wird nachdem der erste Eingang zu dem ersten Logikwert übergeht und der zweite Ausgang ausgewählt wird, nachdem der zweite Eingang zu dem zweiten Logikwert übergeht;
wobei der nicht gealterte oszillierende Zustand Auswählen zwischen dem ersten Ausgang und dem zweiten Ausgang aufweist und Koppeln des ausgewählten Signals an den ersten Eingang und den zweiten Eingang und wobei der erste Ausgang ausgewählt wird, nachdem der erste Eingang zu dem zweiten Logikwert übergeht und der zweite Ausgang ausgewählt wird, nachdem der zweite Eingang zu dem ersten Logikwert übergeht.

2. Schaltung nach Anspruch 1, wobei die erste Verzögerungskette eine erste Kette von Verzögerungselementen aufweist, die zwischen den ersten Eingang und den ersten Ausgang gekoppelt sind, und wobei die zweite Verzögerungskette eine zweite Kette von Verzögerungselementen aufweist, die zwischen den zweiten Eingang und den zweiten Ausgang gekoppelt sind.

3. Schaltung nach Anspruch 2, wobei jedes der Verzögerungselemente einen Inverter beinhaltet.

4. Schaltung nach Anspruch 3, wobei jeder Inverter eine Vielzahl von p-Kanal-Transistoren in Reihe und eine Vielzahl von n-Kanal-Transistoren in Reihe aufweist.

5. Schaltung nach Anspruch 1, wobei die Periode der Oszillationen der Taktausgabe in dem gealterten oszillierenden Zustand eine Kombination einer Verzögerung für einen ansteigenden Übergang durch die erste Verzögerungskette, der durch Alterung verlangsamt wird, und einer Verzögerung für einen abnehmenden Übergang durch die zweite Verzögerungskette, der durch Alterung verlangsamt wird, aufweist.

6. Schaltung nach Anspruch 1, wobei die Periode der Oszillationen der Taktausgabe in dem nicht gealterten oszillierenden Zustand eine Kombination einer Verzögerung für einen abnehmenden Übergang durch die erste Verzögerungskette, der nicht durch Alterung verlangsamt wird, und eine Verzögerung für einen ansteigenden Übergang durch die zweite Verzögerungskette, der nicht durch Alterung verlangsamt wird, aufweist.

## Revendications

1. Circuit pour détecter le vieillissement d'un circuit intégré, comprenant :
une première chaîne de retard (411) ayant une première entrée et une première sortie ;
une deuxième chaîne de retard (412) ayant une deuxième entrée et une deuxième sortie ; et
un module de commande (425) agencé pour placer la première chaîne de retard et la deuxième chaîne de retard soit dans un état de vieillissement dans lequel des circuits dans les première et deuxième chaînes de retard vieillissent, soit dans un état oscillant âgé dans lequel la première chaîne de retard est couplée à la deuxième chaîne de retard pour produire une sortie d'horloge oscillant à une fréquence basée sur des retards de circuits âgés, soit dans un état oscillant non âgé dans lequel la première chaîne de retard est couplée à la deuxième chaîne de retard pour produire la sortie d'horloge oscillant à une fréquence basée sur des retards de circuits non âgés ;
dans lequel l'état de vieillissement comprend la fourniture d'une tension de fonctionnement à la première chaîne de retard et à la deuxième chaîne de retard ;
dans lequel l'état de vieillissement comprend en outre la fourniture d'une première valeur logique à la première entrée et d'une deuxième valeur logique à la deuxième entrée, la première valeur logique étant le complément de la deuxième valeur logique ;
dans lequel l'état oscillant âgé comprend une sélection entre la première sortie et la deuxième sortie et le couplage du signal sélectionné à la première entrée et la deuxième entrée, et dans lequel la première sortie est sélectionnée après que la première entrée est passée à la première valeur logique et la deuxième sortie est sélectionnée après que la deuxième entrée est passée à la deuxième valeur logique ;
dans lequel l'état oscillant non âgé comprend une sélection entre la première sortie et la deuxième sortie et le couplage du signal sélectionné à la première entrée et la deuxième entrée, et dans lequel la première sortie est sélectionnée après que la première entrée est passée à la deuxième valeur logique et la deuxième sortie est sélectionnée après que la deuxième entrée est passée à la première valeur logique.

2. Circuit selon la revendication 1, dans lequel la première chaîne de retard comprend une première chaîne d'éléments de retard couplée entre la première entrée et la première sortie, et la deuxième chaîne de retard comprend une deuxième chaîne d'éléments de retard couplée entre la deuxième entrée et la deuxième sortie.

3. Circuit selon la revendication 2, dans lequel chacun des éléments de retard comprend un inverseur.

4. Circuit selon la revendication 3, dans lequel chaque inverseur comprend une pluralité de transistors à canal P en série et une pluralité de transistors à canal N en série.

5. Circuit selon la revendication 1, dans lequel la période des oscillations de la sortie d'horloge dans l'état oscillant âgé comprend la combinaison d'un retard pour une transition montante à travers la première chaîne de retard qui est ralentie par le vieillissement et d'un retard pour une transition descendante à travers la deuxième chaîne de retard qui est ralentie par le vieillissement.

6. Circuit selon la revendication 1, dans lequel la période des oscillations de la sortie d'horloge dans l'état oscillant non âgé comprend la combinaison d'un retard pour une transition descendante à travers la première chaîne de retard qui n'est pas ralentie par le vieillissement et d'un retard pour une transition montante à travers la deuxième chaîne de retard qui n'est pas ralentie par le vieillissement.
